# EUROPEAN PATENT SPECIFICATION

(11) **EP 3 756 423 B1**
(45) Date of publication and mention of the grant of the patent: **24.04.2024**
(21) Application number: 19758027.7
(22) Date of filing: 19.02.2019
(51) Int. Cl.: H05H 1/34, C23C 4/134, H05H 1/24, H05H 1/26

(54) **SINGLE ARC CASCADED LOW PRESSURE COATING GUN UTILIZING A NEUTRODE STACK AS A METHOD OF PLASMA ARC CONTROL**
EINZELLICHTBOGENKASKADIERTE NIEDERDRUCKBESCHICHTUNGSPISTOLE UNTER VERWENDUNG EINES NEUTRODENSTAPELS ALS VERFAHREN ZUR PLASMALICHTBOGENKONTROLLE
PISTOLET DE REVÊTEMENT BASSE PRESSION EN CASCADE À ARC UNIQUE UTILISANT UNE PILE DE NEUTRODES COMME PROCÉDÉ DE COMMANDE D'ARC PLASMA

(30) Priority: 20.02.2018 US 201862632899 P
(43) Date of publication of application: 30.12.2020
(73) Proprietor: Oerlikon Metco (US) Inc., Westbury, NY 11590 (US)
(72) Inventor: HAWLEY, David, Kings Park, New York 11754 (US); COLMENARES, Jose, Malverne, New York 11565 (US); GUTLEBER, Jonathan, Westbury, New York 11590 (US)
(74) Representative: IPS Irsch AG
(86) International application number: PCT/US2019/018539
(87) International publication number: WO 2019/164822

(56) References cited:
- EP-A2- 0 289 961
- WO-A1-2004/105450
- WO-A1-2018/035619
- WO-A1-2018/170090
- US-A- 3 343 027
- US-A1- 2012 240 771
- US-A1- 2014 326 703
- US-A1- 2016 296 955

## Description

### CROSS-REFERENCE TO RELATED APPLICATION

This International Application claims the benefit of U.S. Provisional Application No. 62/632,899 filed February 20, 2018.

### BACKGROUND OF THE INVENTION

### 1. FIELD OF THE INVENTION

Embodiments are directed to vacuum plasma guns, and more particularly to operating a vacuum plasma gun having a neutrode stack of a cascade type plasma gun or an optimized neutrode stack of a cascade type plasma gun.

### 2. DISCUSSION OF BACKGROUND INFORMATION

Cascade type plasma guns provide advantages of allowing higher voltages and more stable plasma arcs resulting in more stable gun power. The drawback of such guns is the heat rejection resulting from the plasma arc traveling down a relatively long neutrode stack results in higher thermal losses and limits the practical length of the neutrode stack. Longer stacks result in higher thermal losses offsetting the advantages of higher voltages and more stable arcs. What is needed is a structure that optimizes the cooling in order to limit thermal losses without resulting in thermal damage to the neutrode stack.

Current neutrode stacks utilize drilled holes concentrically placed as close as practical to the plasma bore so as to remove heat that would result in damage to the neutrodes, the insulators, or the sealing O-rings. Plasma temperatures inside the plasma bore often exceed 20,000K so cooling of the stack is an essential requirement to prevent damage to the components.

Existing cooling designs for conventional plasma gun nozzles, water cooling channels and/or holes, are typically placed as close to the plasma gun bore as possible to keep temperature of the bore materials as low as possible to prevent damage. This design was carried into the designs for neutrodes as an effective way of cooling.

Recent inventive discoveries covering thermally optimized plasma gun nozzles, e.g., International Application No. PCT/US2013/076603, it was discovered that the nozzle cooling could be altered by moving the water passages away from the plasma gun bore and allow the copper material to move the heat reducing peak temperatures while increasing average temperatures. The water cooling cross section could be reduced to increase water velocity to provide effective cooling sufficient to maintain reasonable temperatures for the plasma gun nozzle while allowing for the increase in average temperature along the bore of the plasma nozzle Documents WO 2018/170090 A1 and WO 2018/035619 A1 belong to the prior art according to Article 54(3) EPC and relate to plasma guns with neutrode stacks. Further cascade plasma guns are known from EP 0 289 961 A2 and WO 2004/105450 A1.

### SUMMARY OF THE EMBODIMENTS

In embodiments, the incorporation of a neutrode stack assembly or of an optimized neutrode stack assembly to a traditional vacuum plasma gun provides unique benefits in vacuum plasma processing, specifically: elimination of Helium or any other secondary gas, reduction of required current facilitating higher power operation and/ or smaller power supplies. Existing vacuum plasma guns always require secondary gasses which are largely limited to the monatomics, such as helium, which are non-renewable resources that can become scarce or even unavailable. The optimized neutrode stack assembly is described in International Publication No. WO 2018/170090 published September 20, 2018, which claims the benefit of Application No. U.S. Provisional Application No. 62/472,202 filed March 16, 2017.

Embodiments of the invention are directed to operating a vacuum plasma gun that has been modified to include a neutrode stack or an optimized neutrode stack of a cascade-type plasma gun. In this manner, while known vacuum plasma guns, such as the Oerlikon Metco 03CP, require up to 2400 amps to support some coating requirements, the same coating can be produced using the vacuum plasma gun modified in accordance with the embodiments with as little as 1200 amps. In this way, practical limits can be placed on the total power available from the state of the art guns.

In addition to the use of known neutrode stacks for cascade-type plasma gun, embodiments of the invention are directed to design and implementation of a thermally optimized neutrode stack for use in vacuum plasma guns in order to reduce the thermal loss to the water while minimizing peak stack temperatures. Optimizing the cooling will permit longer neutrode stacks to be used without the penalty of high thermal losses.

In this regard, the inventors discovered that the technique of moving the water passages away from the plasma gun bore, which allows the copper material of the neutrode to move the heat reducing peak temperatures while increasing average temperatures, could be used on a vacuum plasma gun neutrode stack to improve the cooling characteristics without adverse effect on gun behavior.

In embodiments, the existing Oerlikon Metco 03CP vacuum gun can be modified to include the neutrode stack arrangement utilized in the Oerlikon Metco Triplex and/or Sinplex gun types or to include the optimized neutrode stack described herein. The processes, referred to as Vacuum plasma Spray (VPS), Low Pressure Plasma Spray (LPPS, LVPS) and Reduced Pressure Vacuum Spray (RPPS), require guns having specific design considerations to operate in reduced pressure environments which are not incorporated into the existing cascaded plasma guns. These considerations include, e.g., gas tight electrical isolation at the (-) negative connection region, and nozzle interior design geometry configuration for reduced pressure plume generation.

Embodiment are directed to a vacuum plasma gun that includes a rear gun body section comprising an electrode; and a cascade section configured to connect to the rear gun body section. The cascade section includes a plurality of neutrodes arranged to form a neutrode stack.

According to embodiments, a single gas is supplied as an only plasma gas source.

In accordance with other embodiments, an operational voltage of the gun is greater than 65 volts.

In other embodiments, the vacuum plasma gun can also include a nozzle coupled to an end of the neutrode stack, whereby the neutrode stack separates the electrode from the nozzle.

According to embodiments, each of the plurality of neutrodes can have a disk shape with a central bore and the plurality of neutrodes may be arranged so the central bores form a central plasma bore of the neutrode stack. The plurality of neutrodes can be electrically isolated from each other by insulators. The insulators may be configured to maintain an air or gas gap between adjacent neutrodes. Further, each of the plurality of neutrodes includes a plurality of cooling channels surrounding the central bore. The plurality of cooling channels include axial bores extending through the disk. Moreover, the axial bores can be delimited within the neutrodes. In this regard, the axial bores may have a generally circular geometry through the neutrodes. Alternatively, the axial bores can be recesses open to an outer periphery of the neutrodes. The axial bores can have parallel side walls and a bottom wall generally perpendicular to the side walls.

In accordance with the embodiments, the plurality of neutrodes include disk shaped bodies having central axial bores, outer peripheral surfaces and can include pluralities of recesses surrounding the central axial bores.

In other embodiments, the plurality of neutrodes can be arranged so that the pluralities of recesses are aligned to form a plurality of axial cooling channels in the neutrode stack.

According to still other embodiments, the vacuum plasma gun may be configured for at least one of a vacuum plasma spray (VPS), low pressure plasma spray (LPPS, LVPS) or reduced pressure vacuum spray (RPPS) processes.

Embodiments are directed to a method of controlling plasma arc in a vacuum plasma gun that includes connecting a cascade neutrode stack to a rear body section of a vacuum plasma gun.

According to embodiments, the method can further include connecting the composite plasma gun to a single gas, which is used as an only plasma gas source.

In other embodiments, the method may further include supplying an operational voltage to the composite plasma gun of greater than 65 volts.

In accordance with still yet other embodiments, the cascade neutrode stack can include a plurality of neutrodes, in which each neutrode includes a disk shaped body having a central axial bore and a plurality of recesses surrounding the central axial bore. Moreover, the method can also include orienting the plurality of neutrodes in the cascade neutrode stack so that the plurality of recesses is axially aligned to form a plurality of axial cooling channels through the cascade neutrode stack.

Other exemplary embodiments and advantages of the present invention may be ascertained by reviewing the present disclosure and the accompanying drawing.

### BRIEF DESCRIPTION OF THE DRAWINGS

The present invention is further described in the detailed description which follows, in reference to the noted plurality of drawings by way of non-limiting examples of exemplary embodiments of the present invention, in which like reference numerals represent similar parts throughout the several views of the drawings, and wherein:
Fig. 1 illustrates a composite gun formed from a vacuum plasma gun rear and a cascade section of a cascade-type plasma gun;
Figs. 2A - 2E illustrate various views of an exemplary optimized neutrode in accordance with embodiments of the invention;
Fig. 3 illustrates a cross-sectional view of an embodiment of a neutrode stack, which includes a number of the optimized neutrodes depicted in Fig. 2;
Fig. 4 illustrates the embodiment depicted in Fig. 3, in which the outer peripheries of the stacked optimized neutrodes are illustrated; and
Fig. 5 illustrates another embodiment of an optimized neutrode in accordance with embodiments of the invention; and
Fig. 6 illustrates a conventional neutrode of a known cascaded plasma gun.

### DETAILED DESCRIPTION OF THE EMBODIMENTS

The particulars shown herein are by way of example and for purposes of illustrative discussion of the embodiments of the present invention only and are presented in the cause of providing what is believed to be the most useful and readily understood description of the principles and conceptual aspects of the present invention. In this regard, no attempt is made to show structural details of the present invention in more detail than is necessary for the fundamental understanding of the present invention, the description taken with the drawings making apparent to those skilled in the art how the several forms of the present invention may be embodied in practice.

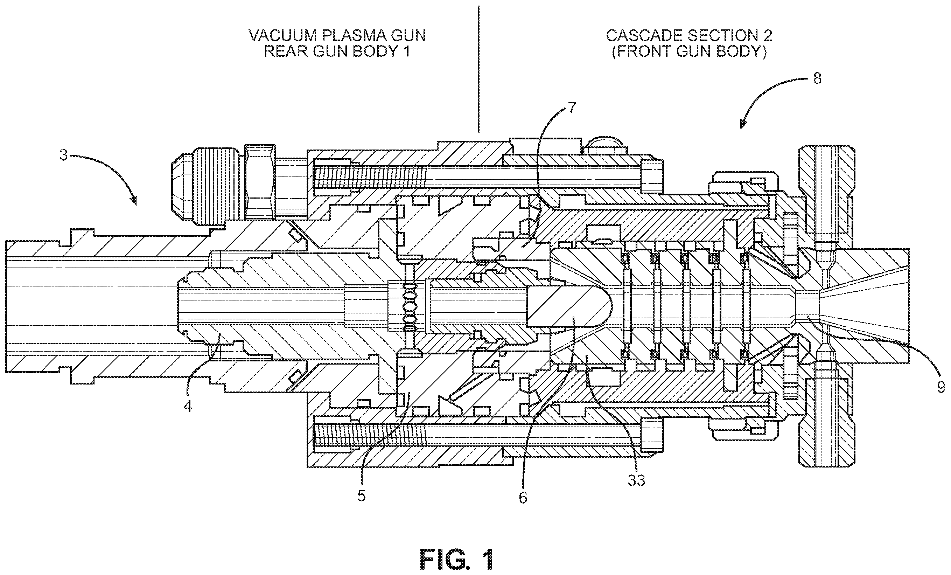

In embodiments, a composite (vacuum) plasma gun can be formed from part of a known vacuum plasma gun that has been modified to include part of a cascade-type plasma gun utilizing a neutrode stack. In this way, a single arc cascaded low pressure coating gun utilizes the neutrode stack as a method of plasma arc control and extension. In particular, as shown in Fig. 1, a composite plasma gun can include a negative (rear) section 1 having a structure corresponding to a vacuum plasma gun, e.g., Oerlikon Metco 03CP gun, and a positive (front) gun section 2 having a structure corresponding to a cascade-type plasma gun that includes a specifically designed neutrode stack assembly. Further, it is contemplated that composite plasma gun can be a retrofitted vacuum plasma gun, in which the positive (front) section of a conventional vacuum plasma gun is removed from the negative (rear) section 1 and replaced with a redesigned positive (front) gun section 2 of a cascade-type plasma gun that includes a specifically designed neutrode stack assembly. The neutrode stack assembly is designed in such a fashion that the operational voltage of the gun will be higher than 65 volts when using a single gas as the only plasma gas source, as compared to the conventional Oerlikon Metco 03CP gun, which operates at 35 to 60 Volts using both Argon as a primary gas and Helium as a secondary gas. The front of the composite plasma gun incorporates water cooling circuits suitable for gun operation at up to 2000 Amps.

Negative (rear) section 1 of composite plasma gun comprises a rear insulator assay 3, which includes an electrode holder 4 structured to hold electrode (cathode) 6. Electrode 6 is further held within middle insulator 5, which abuts electrode holder 4. Electrode 6 extends outwardly from negative (rear) section 2. Positive (front) section 2 of composite plasma gun comprises a neutrode stack 8. Neutrode stack 8 includes, at an interior end, an end piece 33 having a conical opening that accommodates electrode 6 and, at an exterior end, a nozzle (anode) 9. Nozzle 9 can include, e.g., powder injectors, for supplying powder to a generated plasma jet before exiting nozzle 9. Between negative (rear) section 1 and positive (front) section 2, a gas ring 7 is arranged to prevent gas leakage,

Thus, this composite plasma gun is different from the known Oerlikon Metco 03CP because it includes a neutrode stack between the electrode and nozzle, which makes the arc longer allowing for higher operational voltages and lower currents for the same power levels. This also allows the composite plasma gun to run higher voltages without damaging the gun with too much current, so that power can be increased to levels that the conventional single gas operation of the Oerlikon Metco 03CP could not handle. Further, the known Oerlikon Metco 03CP requires up to 2400 amps to support some coating requirements, while the same coatings can be produced using the composite plasma gun in accordance with embodiments of the invention with as little as 1200 amps. In this manner, practical limits can be placed on the total power available from the state of the art guns

The single arc cascaded low pressure coating gun (composite plasma gun) is an improvement in the field of low pressure plasma spray coating production. The gun incorporates the existing body of knowledge from reduced pressure plasma spraying and solves known problems within the existing process while increasing efficiencies and lowering application costs. Key to this is the addition of the neutrode stack assembly to create a "cascaded" plasma gun arrangement adapted to the low pressure environment. A key feature of the design is its ability to replicate qualified industrial coatings without the use of Helium or any other secondary or ternary gas usage.

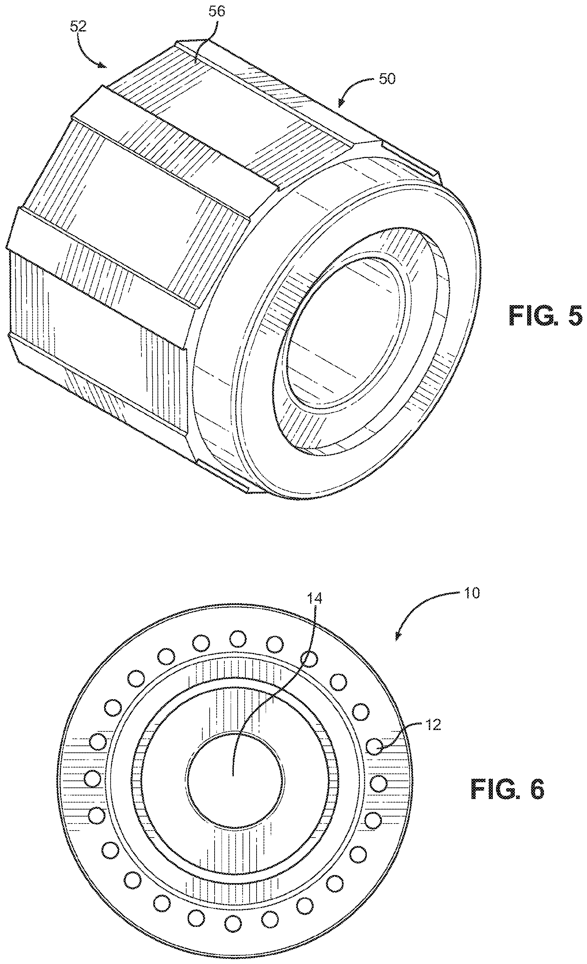

Figure 6 shows a cross sectional view of a conventional neutrode 10 from an existing cascaded plasma gun. It is apparent that the cooling in the conventional neutrode is provided by twenty four (24) holes 12 arranged around the central plasma bore 14 in proximity to the bore. Such conventional neutrodes 10 can be stacked together in the manner described in relation to use in known cascade-type plasma guns, such as, e.g., Oerlikon Metco Triplex and Sinplex gun types. In particular, neutrodes 10 can be electrically isolated from each other by positioning insulators between adjacent neutrodes 10 to maintain an air or gas gap between the adjacent neutrodes 10. Further, seals can be provided between holes 12 and central plasma bore 14 to prevent leakage of the cooling water into central plasma bore 14.

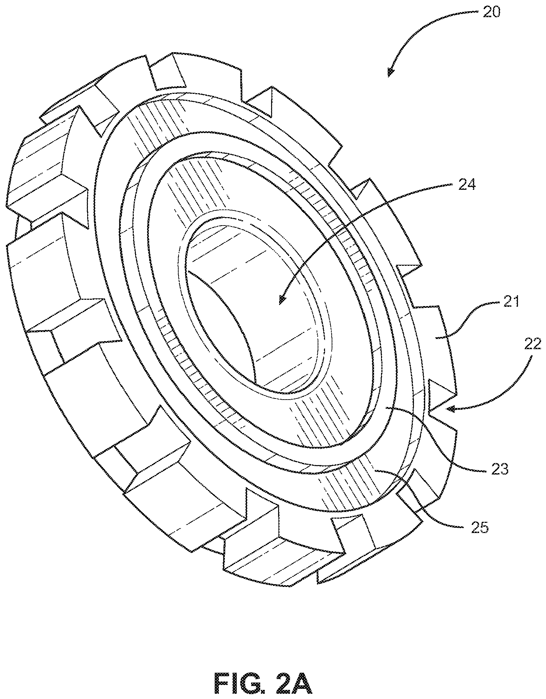

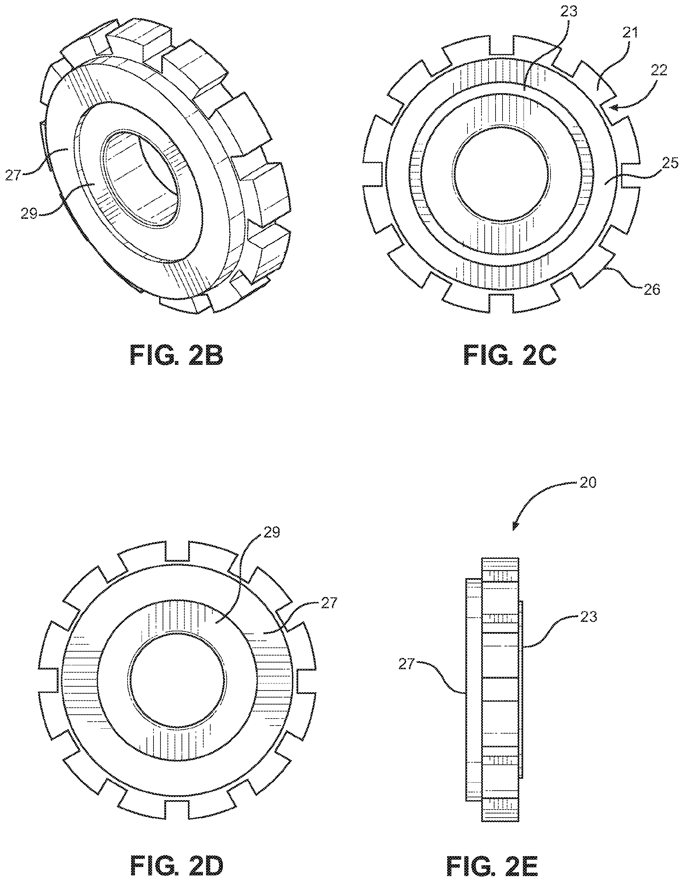

In contrast to the conventional neutrode 10, Figs. 2A - 2E show various views of an exemplary embodiment of a neutrode 20 of an optimized neutrode stack, as described in International Publication No. WO 2018/170090 published September 20, 2018, which claims the benefit of Application No. U.S. Provisional Application No. 62/472,202 filed March 16, 2017. Neutrode 20, as shown in the exemplary illustration, can include twelve (12) axial cooling channels 22 recessed in a body of neutrode 20 and are open to an outer peripheral surface 26 of neutrode 20 surrounding a central plasma bore 24. In this regard, the axially extending through recesses extend outwardly to define protrusions 21, which include portions of outer peripheral surface 26, such that outer peripheral surface 26 is circumferentially discontinuous. On a first side of neutrode 20, e.g., right-hand side shown perspectively in Fig 2A and shown in plan view in Fig. 2C, a ridge 23 axially extends from a recessed surface 25 located below the right-hand side of protrusions 21. On a second side of neutrode 20, e.g., left-hand side shown perspectively in Fig 2B and shown in plan view in Fig. 2D, a ridge 27 axially extends from a surface 29, which can be coplanar with the left-hand side of protrusions 21. Fig. 2E depicts a side view of neutrode 20 in which the axial extensions of ridges 23 and 27 extend beyond the planes of the left-hand and right-hand sides of protrusions 21. Further, in the non-limiting illustrated embodiment of Figs. 2A - 2E, the neutrode can generally has a gear shape, except the side walls of cooling channels 22 are preferably parallel to each other and the bottom wall is generally perpendicular to the side walls. Moreover, in the plan view of Figs. 2C and 2D, cooling channels 22 exhibit a generally square shape in which a width of the recess, which is preferably constant over its depth, is substantially equal to the depth of the recess. While twelve axial channels are formed in the exemplary illustrations of neutrode 20, it is understood that neutrode 20 is not limited to only twelve axial channels, such that more or fewer axial channels can be formed in neutrode 20 without departing from the scope of the invention.

By way of non-limiting example, when viewed in the plan view depicted in at Figs. 2C and 2D, channels 22 defined between protrusions 21 and/or recessed in the neutrode body and open to outer peripheral surface 26 have depth and width dimensions defining areas of channels 22. In a non-limiting example, channels 22 can have a base dimension of 0.125" (3.175 mm) wide by 0.097" (2.464 mm) deep, which provides a total area of 0.1476 square inches (95.22 mm²). When operated at, e.g., a water flow of twenty two (22) liters per minute, the average water velocity through the channels can be, e.g., 3.8 m/sec. However, as noted above, these values for the channel are merely exemplary and the number and size of cooling channels 22 formed between protrusions 21 and/or recessed below and open to outer peripheral surface 26 of neutrode 20 depends upon the water flow needed to prevent temperatures from reaching levels that could damage the gun. By way of further example, channels 22 can be formed to be understood to be substantially square shaped in that the dimension for the depth is substantially the same as the dimension for the width, which is preferably a constant width, of channels 22. Further, while the substantially square shaped channels have a generally 1:1 ratio of width dimension forming a base of the channels to depth dimension below the outer peripheral surface, it is further understood that the ratio of width to depth for the cooling channels can vary within a range of ratios between 1:1 - 8:1.

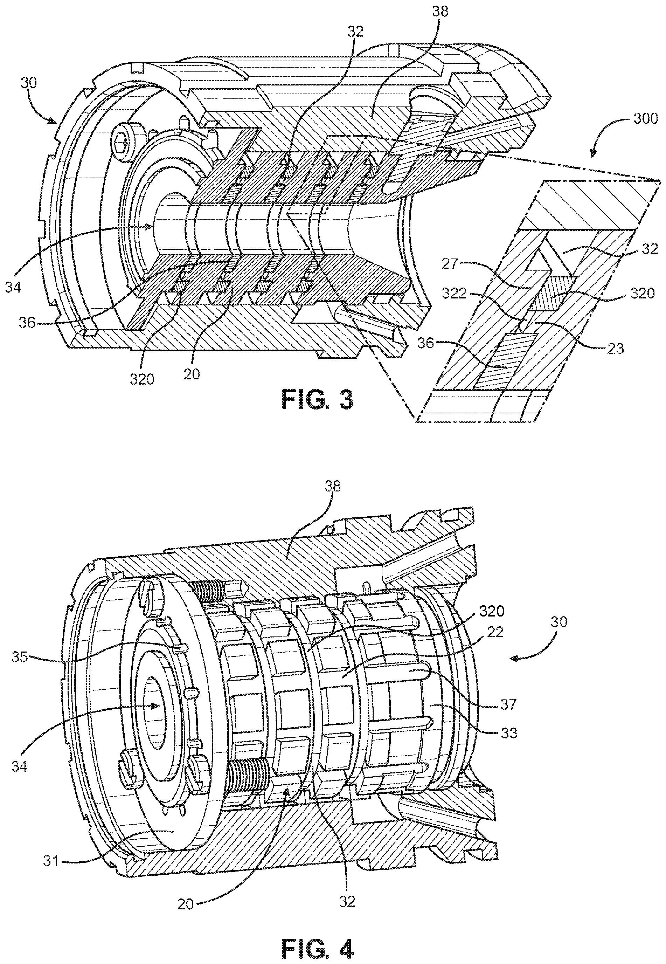

Figure 3 shows a cross-sectional view of an exemplary neutrode stack 30 in a neutrode housing 38, which includes a plurality of the optimized neutrodes 20 depicted in Figs. 2A - 2E, which are coaxially stacked together, and Fig. 4 shows an alternative view of Fig. 3, in which the outer peripheries 26 of components within a cross-sectional view of neutrode stack housing 38, including the outer peripheries of the stacked optimized neutrodes 20, are shown. In the illustrated embodiments, when viewed from the left-hand side of neutrode stack 30, neutrodes 20 depicted in Fig. 2, can be located in, e.g., the second, third and fourth positions. However, the individual neutrodes 20 are isolated from each other, e.g., electrically isolated and physically spaced, so that adjacent neutrodes 20 do not contact each other in neutrode stack 30. Further, neutrode housing 38 can be made of, e.g., plastic, to likewise maintain the isolation between adjacent neutrodes 20 in neutrode stack 30.

As shown in Fig. 3, neutrodes 20 are concentrically aligned along central plasma bores 24 to form neutrode stack 30. In an advantageous and non-limiting embodiment, each neutrode 20 of neutrode stack 30 can have the same number of cooling channels and be oriented so that cooling channels 22 are axially aligned, as depicted in Fig. 4. As neutrodes 20 are isolated from each other in neutrode stack 30, an insulator 36 can be arranged between adjacent neutrodes 20 as a separator. Insulator 36 can be, e.g., boron nitrite, and can be located radially inside ridge 23 and extend radially inwardly to central plasma bore 34 of neutrode stack 30. In embodiments, transitions between central plasma bores 24 of individual neutrodes 20 and insulator 36 within central plasma bore 34 of neutrode 30 can be smooth. As more particularly shown in the inset 300, insulator 36 is suitably thick to maintain an air or gas gap 322 of, e.g., about 0.030" (0.76 mm) between facing surfaces of ridge 23 of a first neutrode 20 and ridge 27 of an adjacent neutrode 20. Further, radially outside of ridge 23, a seal 320, such as an O-ring, which can be made of, e.g., silicon, synthetic rubber such as, e.g., VITON^{®}, nitrile rubber such as BUNA-N, or other suitable water sealing material suited to withstand the temperatures generated within the region of neutrode stack 30, can be arranged between the facing surfaces of adjacent neutrodes 20 in order to form and cover air or gas gap 322 and, thereby prevent cooling water ingress from the cooling channels radially inwardly into air or gas gap 322.

In the illustrated embodiments, neutrode stack 30 may be sandwiched between a larger diameter disk 31 having cooling water holes 35 and an end piece 33 having cooling channels 37, which can be terminated or blind cooling channels. End piece 33 can include an axially arranged conical depression, into which, the electrode (cathode) is positionable, as shown in Fig. 1. In advantageous and non-limiting embodiments, disk 31 includes a number of cooling water holes 35, which corresponds to the number of cooling channels 22 in each neutrode 20 and to the number of cooling channels 37 in end piece 33. On the surface of disk 1 opposite end piece 33, the nozzle (anode) is positionable, as shown in Fig. 1. As with the adjacent neutrodes 20 in neutrode stack 30, an insulator 36 and a seal 320 can be arranged between disk 31 and the nozzle in order to form and cover an air or gas gap 322 that prevents cooling water ingress from the cooling channels radially inwardly into this air or gas gap 322.

Further, cooling water holes 35, cooling channels 22 and cooling channels 37 can be oriented so as to be axially aligned, as depicted in Fig. 4. Still further, as the radially extending portions of neutrodes 20 that include peripheral surface 26 are separated from each other in the axial direction, circumferential cooling channels 32 are formed in neutrode stack 30. Larger diameter of disk 31 can be coupled housing 38, e.g., via screws, bolts, clamps, etc., and in doing so, can also bias stacked optimized neutrodes 20, insulators 36, seals 320 and end piece 33 together. Advantageously, the biasing is sufficient so that seals 320 suitably engage the facing surfaces of adjacent neutrodes to achieve a desired water sealing configuration. In embodiments, it is readily understood that neutrode stack 30 can include more or even fewer of the optimized neutrodes depicted in Figs. 2A - 2E. Moreover, it is further understood that neutrode stack housing 38 can include similar cooling channels formed in or on the outer periphery of the housing.

Figure 5 shows another exemplary embodiment of a neutrode 50. In this embodiment, neutrode 50 can include eight (8) flattened cooling channels 52 formed in and around the outer periphery 56 of neutrode 50. By way of non-limiting example, flattened channels 52 formed in periphery 56 of neutrode 50 can be 0.200" (5.08 mm) wide by 0.0225" (0.572 mm) deep, which provides a total area of 0.032 square inches (20.65 mm²). When operated at a water flow of 9 liters per minute the average water velocity through the channels is 6.4 m/sec. However, as noted above, these values for the channel are merely exemplary and the number and size of the cooling channels depends upon the water flow needed to prevent temperatures from reaching levels that could damage the gun.

According to embodiments, a neutrode stack can be provided with water cooling channels arranged at an outer perimeter of each optimized neutrode, as shown, e.g., in Figs. 2A, 5. The cross sectional areas of the channels can be designed to create high water velocities, e.g., greater than 1.0 m/sec, preferably greater than 2.0 m/sec, and most preferably greater than 3.0 m/sec. Each channel can be structured with shapes ranging from a roughly square shape, see, e.g., Fig. 2A - 2E, to an elongated and flattened shape, see, e.g., Fig. 5, in order to maximize the water cooling flow at the outermost periphery of the neutrodes 20. Moreover, the channels can also be structured or formed with triangular cross-sections and arranged to maximize the water cooling flow at the outer periphery of each neutrode. The number and size and geometry of the cooling channels are dependent upon the required water flow to prevent temperatures from reaching levels that could damage the gun. The total number of neutrodes in the neutrode stack or thickness of each neutrode of the neutrode stack is not limited in this design. In fact, with the optimized neutrodes according to embodiments, longer neutrode stacks are now possible with limited thermal cooling losses.

It is noted that the embodiments are not limited to the above-described specific examples of base to depth ratios for the cooling channels. It is understood that the ratio of base to depth for the cooling channels can be up to 1:1 to achieve cooling channels ranging from taller radial profiles to a generally square cross-section, greater than 8:1 to achieve a flatter profile cross-sections, and any ratio within the range between 1:1 and 8:1. Thus, the ratio can be, but again is not limited to, specific ratios of base to depth of 2:1, 3:1, 4:1, 5:1, 6:1, 7:1, as well as any ratios there between.

In the composite plasma gun in accordance with the described embodiments utilizing a neutrode stack formed by a plurality of neutrodes 50, as depicted in Fig. 5, water flow in a plasma gun, as computed via known computational fluid dynamics (CFD) software, reveals that with a 8.1 liters per minute water flow, the average water velocity in the neutrode stack was above 3.2 m/sec.

A composite plasma gun incorporating neutrode stack 30, as depicted in Fig. 3, was tested and compared to a conventional plasma gun of the same overall design, which included a long nozzle that used water cooling fins or channels to cool the plasma nozzle. The test results showed a 10% increase in thermal efficiency with the gun using neutrode stack 30 according to the embodiments of the invention over the conventionally cooled nozzle. Other testing showed that adding conventional neutrode stacks to plasma guns reduced thermal efficiency from between 6% and 10%. Still further testing showed that doubling the length of a conventional neutrode stack for a plasma gun reduced thermal efficiency by 20% while increasing the length of neutrode stack 30 with added optimized neutrodes 20 had a much lower decrease in thermal efficiency, which worked out to be about less than one-half that of conventional neutrode stacks. Moreover, duration testing of neutrode stack 30 showed no adverse thermal effects even after more than 200 hours of testing with the same stack.

It is noted that the foregoing examples have been provided merely for the purpose of explanation and are in no way to be construed as limiting of the present invention. While the present invention has been described with reference to an exemplary embodiment, it is understood that the words which have been used herein are words of description and illustration, rather than words of limitation. Changes may be made, within the purview of the appended claims, as presently stated and as amended, without departing from the scope of the present invention in its aspects. Although the present invention has been described herein with reference to particular means, materials and embodiments, the present invention is not intended to be limited to the particulars disclosed herein; rather, the present invention extends to all functionally equivalent structures, and methods, such as are within the scope of the appended claims.

## Claims

1. A vacuum plasma gun comprising:
a rear gun body section (1) comprising an electrode (6); and
a cascade section (2) configured to connect to the rear gun body section,
wherein the cascade section comprises a plurality of neutrodes (20, 50) arranged to form a neutrode stack (8, 30), wherein the neutrodes have a disk-shaped body having an outer peripheral surface (26) and a central bore (24); and a plurality of cooling channels (22, 52) formed at least one of in or on the outer peripheral surface,
**characterized in that** the plurality of cooling channels (22) comprises axial bores extending through the disk (20,50).

2. The vacuum plasma gun according to claim 1, wherein a single gas is supplied as an only plasma gas source.

3. The vacuum plasma gun according to claim 1, wherein an operational voltage of the gun is greater than 65 volts.

4. The vacuum plasma gun according to claim 1, further comprising a nozzle (9) coupled to an end of the neutrode stack (8, 30), whereby the neutrode stack separates the electrode (6) from the nozzle.

5. The vacuum plasma gun according to claim 1,
wherein the plurality of neutrodes (20, 50) is arranged so the central bores (24) form a central plasma bore of the neutrode stack (8, 30).

6. The vacuum plasma gun according to claim 5, wherein the plurality of neutrodes (20, 50) are electrically isolated from each other by insulators (36, 320).

7. The vacuum plasma gun according to claim 6, wherein the insulators (36, 320) are configured to maintain an air or gas gap (322) between adjacent neutrodes (20, 50).

8. The vacuum plasma gun according to claim 1, wherein the axial bores are recesses (22, 52) open to an outer periphery (26) of the neutrodes.

9. The vacuum plasma gun according to claim 8, wherein the axial bores have parallel side walls and a bottom wall generally perpendicular to the side walls.

10. The vacuum plasma gun according to claim 8, wherein the plurality of neutrodes (20, 50) are arranged so that the pluralities of recesses (22, 52) are aligned to form a plurality of axial cooling channels (37) in the neutrode stack (8, 30).

11. The vacuum plasma gun according to claim 1, being configured for at least one of a vacuum plasma spray (VPS), low pressure plasma spray (LPPS, LVPS) or reduced pressure vacuum spray (RPPS) processes.

12. A method of controlling plasma arc in a vacuum plasma gun comprising:
connecting a cascade neutrode stack (8, 30) to a rear body section (1) of a vacuum plasma gun, wherein the cascade neutrode stack comprises a plurality of neutrodes (20, 50), and the neutrodes have a disk-shaped body having an outer peripheral surface (26) and a central bore (24); and a plurality of cooling channels (22) formed at least one of in or on the outer peripheral surface, **characterized in that** the plurality of cooling channels (22) comprises axial bores extending through the disk (20,50).

13. The method in according to claim 12, further comprising connecting the composite plasma gun to a single gas, which is used as an only plasma gas source.

14. The method according to claim 12, further comprising supplying an operational voltage to the composite plasma gun of greater than 65 volts.

15. The method according to claim 12, the method further comprises:
orienting the plurality of neutrodes (20,50) in the cascade neutrode stack (8, 30) so that the plurality of cooling channels (22) is axially aligned to form a plurality of axial cooling channels (37) through the cascade neutrode stack.

## Patentansprüche

1. Vakuumplasmapistole, umfassend:
einen hinteren Pistolenkörperabschnitt (1), der eine Elektrode (6) umfasst; und
einen Kaskadenabschnitt (2), der konfiguriert ist, um mit dem hinteren Pistolenkörperabschnitt verbunden zu werden,
wobei der Kaskadenabschnitt eine Vielzahl von Neutroden (20, 50) umfasst, die zur Bildung eines Neutrodenstapels (8, 30) angeordnet sind, wobei die Neutroden einen scheibenförmigen Körper mit einer äusseren Umfangsfläche (26) und einer zentralen Bohrung (24) aufweisen; und eine Vielzahl von Kühlkanälen (22, 52), die zumindest entweder in oder auf der äusseren Umfangsfläche ausgebildet sind,
**dadurch gekennzeichnet, dass** die Vielzahl von Kühlkanälen (22) axiale Bohrungen umfasst, die sich durch die Scheibe (20, 50) erstrecken.

2. Vakuumplasmapistole nach Anspruch 1, wobei ein einziges Gas als eine einzige Plasmagasquelle zugeführt wird.

3. Vakuumplasmapistole nach Anspruch 1, wobei eine Betriebsspannung der Pistole grösser als 65 Volt ist.

4. Vakuumplasmapistole nach Anspruch 1, weiter umfassend eine Düse (9) verbunden mit einem Ende des Neutrodenstapels (8, 30), wodurch der Neutrodenstapel die Elektrode (6) von der Düse trennt.

5. Vakuumplasmapistole nach Anspruch 1, wobei die Vielzahl von Neutroden (20, 50) so angeordnet ist, dass die zentralen Bohrungen (24) eine zentrale Plasmabohrung des Neutrodenstapels (8, 30) bilden.

6. Vakuumplasmapistole nach Anspruch 5, wobei die Vielzahl von Neutroden (20, 50) durch Isolatoren (36, 320) elektrisch voneinander isoliert sind.

7. Vakuumplasmapistole nach Anspruch 6, wobei die Isolatoren (36, 320) konfiguriert sind, um einen Luft- oder Gasspalt (322) zwischen benachbarten Neutroden (20, 50) aufrecht zu erhalten.

8. Vakuumplasmapistole nach Anspruch 1, wobei die axialen Bohrungen Aussparungen (22, 52) sind, die zu einem äusseren Umfang (26) der Neutroden hin offen sind.

9. Vakuumplasmapistole nach Anspruch 8, wobei die axialen Bohrungen parallele Seitenwände und eine untere Wand aufweisen, die normalerweise senkrecht zu den Seitenwänden ist.

10. Vakuumplasmapistole nach Anspruch 8, wobei die Vielzahl von Neutroden (20, 50) so angeordnet ist, dass die Vielzahl von Aussparungen (22, 52) so ausgerichtet sind, dass sie eine Vielzahl von axialen Kühlkanälen (37) in dem Neutrodenstapel (8, 30) bilden.

11. Vakuumplasmapistole nach Anspruch 1, die für mindestens einen der Prozesse Vakuumplasmaspritzen (VPS), Niederdruckplasmaspritzen (LPPS, LVPS) oder Vakuumspritzen mit reduziertem Druck (RPPS) konfiguriert ist.

12. Verfahren zur Steuerung des Plasmabogens in einer Vakuumplasmapistole, umfassend:
Verbinden eines Kaskaden-Neutrodenstapels (8, 30) mit einem hinteren Körperabschnitt (1) einer Vakuumplasmapistole, wobei der Kaskaden-Neutrodenstapel eine Vielzahl von Neutroden (20, 50) umfasst und die Neutroden einen scheibenförmigen Körper mit einer äusseren Umfangsfläche (26) und einer zentralen Bohrung (24) aufweisen; und eine Vielzahl von Kühlkanälen (22, 52), die zumindest entweder in oder auf der äusseren Umfangsfläche ausgebildet sind, **dadurch gekennzeichnet, dass** die Vielzahl von Kühlkanälen (22) axiale Bohrungen umfasst, die sich durch die Scheibe (20, 50) erstrecken.

13. Verfahren nach Anspruch 12, weiter umfassend den Anschluss der zusammengesetzten Plasmapistole an ein einziges Gas, das als einzige Plasmagasquelle verwendet wird.

14. Verfahren nach Anspruch 12, weiter umfassend das Zuführen einer Betriebsspannung an die zusammengesetzte Plasmapistole von mehr als 65 Volt.

15. Verfahren nach Anspruch 12, wobei das Verfahren weiter umfasst:
Ausrichten der Vielzahl von Neutroden (20, 50) in dem Kaskaden-Neutrodenstapel (8, 30), so dass die Vielzahl von Kühlkanälen (22) axial ausgerichtet ist, um eine Vielzahl von axialen Kühlkanälen (37) durch den Kaskaden-Neutrodenstapel zu bilden.

## Revendications

1. Un pistolet à plasma sous vide comprenant :
une section de corps de pistolet arrière (1) comprenant une électrode (6) ; et
une section en cascade (2) configurée pour se raccorder à la section de corps de pistolet arrière,
dans lequel la section en cascade comprend une pluralité de neutrodes (20, 50) agencée pour former un empilement de neutrodes (8, 30), dans lequel les neutrodes ont un corps en forme de disque ayant une surface périphérique externe (26) et un alésage central (24) ; et une pluralité de canaux de refroidissement (22, 52) formée au moins dans ou sur la surface périphérique externe,
**caractérisé en ce que** la pluralité de canaux de refroidissement (22) comprend des alésages axiaux s'étendant à travers le disque (20, 50).

2. Le pistolet à plasma sous vide selon la revendication 1, dans lequel un seul gaz est fourni comme source unique de gaz de plasma.

3. Le pistolet à plasma sous vide selon la revendication 1, dans lequel une tension de fonctionnement du pistolet est plus de 65 volts.

4. Le pistolet à plasma sous vide selon la revendication 1, comprenant en outre une buse (9) couplée à une extrémité de l'empilement de neutrodes (8, 30), moyennant quoi l'empilement de neutrodes sépare l'électrode (6) de la buse.

5. Le pistolet à plasma sous vide selon la revendication 1, dans lequel la pluralité de neutrodes (20, 50) est agencée de sorte que les alésages centraux (24) forment un alésage de plasma central de l'empilement de neutrodes (8, 30).

6. Le pistolet à plasma sous vide selon la revendication 5, dans lequel la pluralité de neutrodes (20, 50) sont isolés électriquement les uns des autres par des isolants (36, 320).

7. Le pistolet à plasma sous vide selon la revendication 6, dans lequel les isolants (36, 320) sont configurés pour maintenir un espace d'air ou de gaz (322) entre des neutrodes adjacents (20, 50).

8. Le pistolet à plasma sous vide selon la revendication 1, dans lequel les alésages axiaux sont des évidements (22, 52) ouverts sur une périphérie externe (26) des neutrodes.

9. Le pistolet à plasma sous vide selon la revendication 8, dans lequel les alésages axiaux ont des parois latérales parallèles et une paroi bas généralement perpendiculaire aux parois latérales.

10. Le pistolet à plasma sous vide selon la revendication 8, dans lequel la pluralité de neutrodes (20, 50) est agencée de sorte que les pluralités d'évidements (22, 52) sont alignées pour former une pluralité de canaux de refroidissement axiaux (37) dans l'empilement de neutrodes (8, 30).

11. Le pistolet à plasma sous vide selon la revendication 1, étant configuré pour au moins l'un d'un procédé de pulvérisation de plasma sous vide (VPS), de pulvérisation de plasma à basse pression (LPPS, LVPS) ou de pulvérisation sous vide à pression réduite (RPPS).

12. Un procédé de commande d'arc de plasma dans un pistolet à plasma sous vide, comprenant :
le raccordement d'un empilement de neutrodes en cascade (8, 30) à une section de corps arrière (1) d'un pistolet à plasma sous vide, dans lequel l'empilement de neutrodes en cascade comprend une pluralité de neutrodes (20, 50), et les neutrodes ont un corps en forme de disque ayant une surface périphérique externe (26) et un alésage central (24) ; et une pluralité de canaux de refroidissement (22) formée au moins dans ou sur la surface périphérique externe, **caractérisé en ce que** la pluralité de canaux de refroidissement (22) comprend des alésages axiaux s'étendant à travers le disque (20, 50).

13. Le procédé selon la revendication 12, comprenant en outre le raccordement du pistolet à plasma composite à un seul gaz, qui est utilisé en tant que source unique de gaz de plasma.

14. Le procédé selon la revendication 12, comprenant en outre la fourniture d'une tension de fonctionnement au pistolet à plasma composite de plus de 65 volts.

15. Le procédé selon la revendication 12, le procédé comprenant en outre :
l'orientation de la pluralité de neutrodes (20, 50) dans l'empilement de neutrodes en cascade (8, 30) de sorte que la pluralité de canaux de refroidissement (22) est alignée axialement pour former une pluralité de canaux de refroidissement axiaux (37) à travers l'empilement de neutrodes en cascade.
